# FASCICULE DE BREVET EUROPEEN

(11) **EP 2 764 550 B1**
(45) Date de publication et mention de la délivrance du brevet: **31.08.2016**
(21) Numéro de dépôt: 12779113.5
(22) Date de dépôt: 04.10.2012
(51) Int. Cl.: H01L 27/108, H01L 21/84, H01L 27/12, G11C 11/404, H01L 29/78

(54) **POINT MÉMOIRE RAM A UN TRANSISTOR**
RAM-SPEICHERPUNKT MIT EINEM TRANSISTOR
RAM MEMORY POINT WITH A TRANSISTOR

(30) Priorité: 04.10.2011 FR 1158942
(43) Date de publication de la demande: 13.08.2014
(73) Titulaire: Universidad de Granada, 18071 Granada (ES); Centre National de la Recherche Scientifique, 75794 Paris Cedex 16 (FR)
(72) Inventeur: RODRIGUEZ, Noel, E-18.100 Armilla (Granada) (ES); GAMIZ, Francisco, E-18.100 Armilla (Granada) (ES); CRISTOLOVEANU, Sorin, Ioan, F-38170 Seyssinet (FR)
(74) Mandataire: Thibon, Laurent
(86) Numéro de dépôt international: PCT/FR2012/052246
(87) Numéro de publication internationale: WO 2013/050707

(56) Documents cités:
- WO-A1-88/08617
- WO-A1-2010/068385
- WO-A1-2011/124855
- US-A1- 2006 092 739
- US-A1- 2007 278 572
- US-A1- 2010 149 864
- US-A1- 2011 180 871
- ERTOSUN M G ET AL: "Investigation of Capacitorless Double-Gate Single-Transistor DRAM: With and Without Quantum Well", IEEE TRANSACTIONS ON ELECTRON DEVICES, IEEE SERVICE CENTER, PISACATAWAY, NJ, US, vol. 57, no. 3, 1 mars 2010 (2010-03-01), pages 608-613, XP011301186, ISSN: 0018-9383
- GUNHAN ERTOSUN M ET AL: "Characteristics of the Capacitorless Double Gate Quantum Well Single Transistor DRAM", SIMULATION OF SEMICONDUCTOR PROCESSES AND DEVICES, 2009. SISPAD '09. INTERNATIONAL CONFERENCE ON, IEEE, PISCATAWAY, NJ, USA, 9 septembre 2009 (2009-09-09), pages 1-4, XP031548617,
- COLLAERT N ET AL: "Optimizing the Readout Bias for the Capacitorless 1T Bulk FinFET RAM Cell", IEEE ELECTRON DEVICE LETTERS, IEEE SERVICE CENTER, NEW YORK, NY, US, vol. 30, no. 12, 1 décembre 2009 (2009-12-01), pages 1377-1379, XP011284310, ISSN: 0741-3106, DOI: 10.1109/LED.2009.2034395
- TANAKA T ET AL: "Scalability study on a capacitorless 1T-DRAM from single-gate PD-SOI to double-gate FinDRAM", ELECTRON DEVICES MEETING, 2004. IEDM TECHNICAL DIGEST. IEEE INTERNATIO NAL SAN FRANCISCO, CA, USA DEC. 13-15, 2004, PISCATAWAY, NJ, USA,IEEE, 13 décembre 2004 (2004-12-13), pages 919-922, XP010788953, DOI: 10.1109/IEDM.2004.1419332 ISBN: 978-0-7803-8684-6

## Description

### Domaine de l'invention

La présente invention concerne un point mémoire RAM à un transistor.

### Exposé de l'art antérieur

Un point mémoire à un transistor a déjà été décrit par les présents inventeurs dans le document EP2556533.

La figure 1 reproduit la figure 1 de ce document.

Le point mémoire comprend un transistor MOS formé sur une couche isolante 1 reposant sur un support 3, généralement une plaque de silicium. La zone occupée par le transistor MOS, ou zone active, est délimitée par une périphérie isolante 5. Le transistor MOS comprend des régions de source et de drain fortement dopées d'un premier type de conductivité 7 et 8 séparées par une région de corps. Les régions de source et de drain sont respectivement solidaires d'une métallisation de source 10 et d'une métallisation de drain 11 reliées à des bornes de source S et de drain D. La partie de corps du transistor est surmontée d'une grille isolée 12 reliée à une borne de grille G. La région de corps est divisée dans le sens de son épaisseur en une région de corps supérieure 13 du côté de la grille 12 et une région de corps inférieure 14 au voisinage de la couche isolante 1. La région de corps supérieure 13 est du type de conductivité opposé à celui des drain/source et a de préférence un niveau de dopage inférieur à 10¹⁶ atomes/cm³. La région de corps inférieure 14 est du même type de conductivité que celui des drain/source. Son niveau de dopage est de préférence choisi dans une plage de 10¹⁶ à 10¹⁸ atomes/cm³ en fonction de son épaisseur de façon que cette partie inférieure 14 soit complètement déplétée à l'état 0 et qu'elle contienne suffisamment d'électrons disponibles à l'état 1, les états 0 et 1 étant définis ci-après.

EP2556533 décrit également un mode d'écriture et de lecture de ce point mémoire.

Pour écrire un 1, on applique d'abord une tension positive relativement élevée, par exemple 1 à 3 volts, sur le drain du transistor, et la grille est mise à un potentiel positif pendant une courte durée, pendant que la tension positive est appliquée sur le drain. Il en résulte qu'une région de canal est formée dans la région de corps supérieure (pendant cette phase, une faible proportion de courant peut sans inconvénient circuler dans la région de corps inférieure) et que des électrons circulent de la source au drain. Etant donné que la différence de potentiel drain-source est choisie relativement élevée, ces électrons vont créer par impact des paires électrons-trous dans la région de corps supérieure. Les électrons créés participent à la circulation de courant et les trous demeurent dans la région de corps supérieure. Si on interrompt brutalement le passage de courant entre source et drain, en commutant la grille à un potentiel négatif avant de commuter le drain, des trous demeureront dans la région de corps supérieure 13.

Pour écrire un 0 dans le point mémoire, à nouveau, on rend la grille positive mais cette fois-ci, on connecte le drain 8 à une tension faiblement positive, nulle ou même négative. Alors, la différence de potentiel source-drain est insuffisante pour assurer la création de paires électrons-trous, et, en raison de la polarisation électrostatique créée par la grille dans la région de corps supérieure 13, les trous éventuellement présents dans cette région de corps supérieure seront évacués vers le drain et/ou la source. Ainsi, dans un cas (écriture d'un 1), des trous sont stockés dans la région de corps supérieure 13 et dans l'autre cas (écriture d'un 0), aucune charge n'est stockée dans cette région de corps supérieure.

En phase de lecture, une tension négative est appliquée sur la grille et une tension faiblement positive sur le drain. En phase de rétention, une tension négative est appliquée sur la grille et une tension nulle sur le drain.

Dans le cas où un 0 a été mémorisé, c'est-à-dire qu'aucune charge n'est stockée dans la région de corps supérieure 13, les transistors en parallèle partageant un même drain et une même source sont tous deux bloqués : il ne passe pas de courant dans le transistor correspondant à la région de corps supérieure puisque la grille est négative, et la tension négative de grille déplète la région de corps inférieure qui ne laisse donc également pas passer de courant. On comprendra que la région de corps supérieure doit être suffisamment mince pour que la grille ait une influence suffisante sur la région de corps inférieure, c'est pourquoi on a indiqué que cette région de corps supérieure avait une épaisseur de préférence voisine de 10 nm.

Par contre, dans le cas où un 1 a été écrit, c'est-à-dire que des charges positives sont stockées dans la région de corps supérieure 13, aucun courant ne circule dans le transistor correspondant à cette région de corps supérieure puisque la grille est négative et qu'il n'est pas créé de région de canal d'électrons dans cette région de corps supérieure. Par contre, les charges positives stockées dans la région de corps supérieure font écran au potentiel négatif de la grille et un courant d'électrons va circuler dans le transistor ayant pour source et drain les régions 7 et 8 et comme corps la région non déplétée de corps inférieure 14.

Ainsi, on pourra reconnaître un état 1 d'un état 0 par la circulation d'un courant ou l'absence de circulation d'un courant lors d'une phase de lecture.

On notera également que, du fait que pendant l'état de lecture seul un potentiel faiblement positif est appliqué sur le drain, il ne se crée pas de charges par impact dans la région de corps inférieure 14 pendant une lecture.

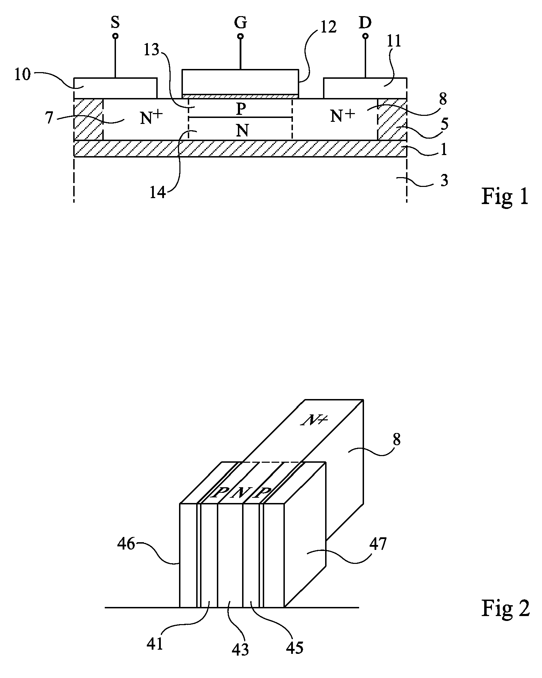

La figure 7 de cette demande de brevet est reproduite dans la figure 2 de la présente demande. Cette figure illustre très schématiquement une réalisation FINFET d'une variante de la structure de la figure 1. Le corps du transistor, au lieu d'être divisé en deux régions, est divisé en trois régions : une région de gauche 41 de type P, une région centrale 43 de type N et une région de droite 45 de type P. Une grille isolée 46 est disposée en regard de la région de gauche 41 et une grille isolée 47 est disposée en regard de la région de droite 45. On obtient ainsi un point mémoire bibit, c'est-à-dire un point mémoire à quatre états. La grille de gauche permet de stocker ou non des charges dans la région de corps de gauche 41. La grille de droite permet de stocker ou non des charges dans la région de corps de droite 45. On obtient un premier état (11) si des charges sont stockées à gauche et à droite, un deuxième état (00) si aucune charge n'est stockée ni à gauche ni à droite, un troisième état (10) si des charges sont stockées à gauche et pas à droite, et un quatrième état (01) si des charges sont stockées dans la région à droite et pas à gauche. Les états (01) et (10) pourront être différenciés de diverses manières. Notamment, si les grilles de gauche et de droite sont différentes (travail de sortie différent ou épaisseur d'isolant différente) et/ou si les tensions appliquées sont différentes, on stockera à chaque écriture d'un 1 une quantité plus ou moins grande de charges dans la région de corps de gauche et dans la région de corps de droite. Ainsi, les quatre valeurs possibles du courant dans la région de corps centrale peuvent être bien différenciées.

On notera que dans la réalisation illustrée en figure 2, les deux grilles sont distinctes et commandées indépendamment pour déterminer des états distincts du point mémoire.

Les documents US2006/0092739, WO88/08617 et US2010/0149864 décrivent d'autres dispositifs de mémoire à semi-conducteurs.

### Résumé

Un objet d'un mode de réalisation de la présente invention est de prévoir une structure de point mémoire à un transistor qui soit encore plus sensible que la structure décrite dans la demande de brevet susmentionnée, c'est-à-dire en particulier qui soit commandable et qui puisse être maintenu en rétention par des tensions plus faibles.

Un objet d'un mode de réalisation de la présente invention est de prévoir un tel point mémoire présentant un rapport entre le courant de lecture à l'état 1 et le courant de lecture à l'état 0 qui soit encore plus important que dans les dispositifs antérieurs.

Un objet d'un mode de réalisation de la présente invention est de prévoir un tel point mémoire qui puisse être encore plus miniaturisé que les dispositifs antérieurs et notamment dont la longueur de grille puisse être plus faible.

Un objet d'un mode de réalisation de la présente invention est de prévoir un tel point mémoire dont la fabrication soit compatible avec les technologies émergentes de transistors FinFET et de transistors à nanofils dans lesquelles la longueur de grille est de 22 nm ou moins.

La présente invention prévoit un point mémoire selon la revendication 1.

Ainsi, un mode de réalisation de la présente invention prévoit un point mémoire constitué d'un bâtonnet semiconducteur dont les extrémités sont fortement dopées pour constituer des régions de source et de drain et dont la partie centrale comprend, entre les régions de source et de drain, une région de type N entourée sur la plus grande partie de sa périphérie d'une région de type P quasi intrinsèque, la région de type P étant elle-même entourée d'une grille isolée.

Selon un mode de réalisation de la présente invention, le niveau de dopage de la région de type N est de l'ordre de 2.10¹⁸ à 2.10¹⁹ atomes par cm³ et le niveau de dopage de la région de type P de l'ordre de 10¹⁴ à 10¹⁶ atomes par cm³.

Selon un mode de réalisation de la présente invention, le bâtonnet est constitué d'un morceau de silicium formé dans une couche de silicium sur isolant.

Selon un mode de réalisation de la présente invention, le bâtonnet est constitué d'un morceau d'un nanofil de silicium.

Selon un mode de réalisation de la présente invention, la longueur de la grille est inférieure à la longueur de la région de type P qu'elle entoure.

### Brève description des dessins

Ces objets, caractéristiques et avantages, ainsi que d'autres seront exposés en détail dans la description suivante de modes de réalisation particuliers faite à titre non limitatif en relation avec les figures jointes parmi lesquelles :
les figures 1 et 2, décrites précédemment, correspondent respectivement aux figures 1 et 7 du document EP2556533;
les figures 3A et 3B sont respectivement une vue en coupe dans une direction longitudinale et une vue en coupe selon le plan BB de la figure 3A d'un mode de réalisation d'un point mémoire à un transistor ; et
les figures 4A et 4B sont respectivement une vue en perspective et une vue en coupe agrandie selon le plan BB de la figure 4A d'un mode de réalisation d'un point mémoire à un transistor.

Comme cela est habituel dans la représentation des micro et nano composants, les diverses figures ne sont pas tracées à l'échelle.

### Description détaillée

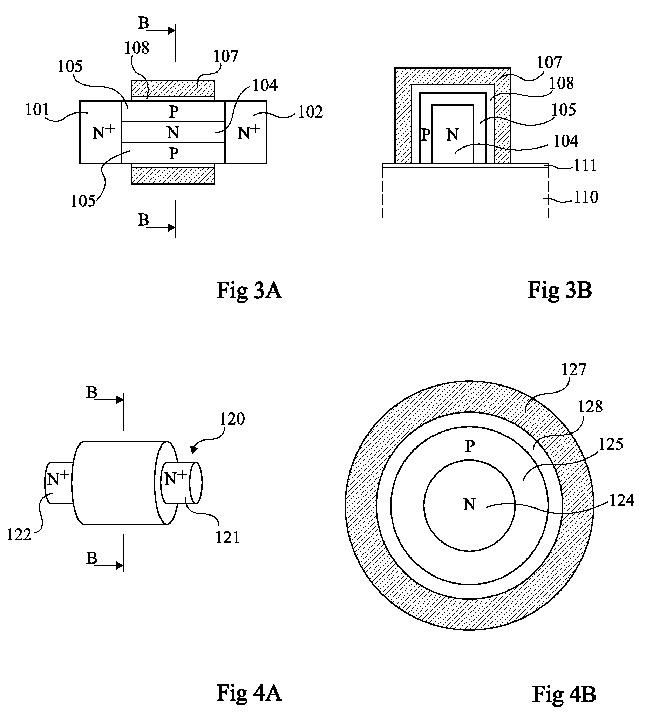

Les figures 3A et 3B sont respectivement une vue en coupe dans une direction longitudinale et une vue en coupe selon le plan BB de la figure 3A d'un mode de réalisation d'un point mémoire à un transistor. Le point mémoire représenté en figures 3A et 3B comprend des régions de source et de drain 101 et 102 séparées par une région intermédiaire comprenant une partie centrale de type N 104 et une partie entourante de type P 105. La partie de type P est elle-même entourée d'un conducteur de grille 107 isolé de cette région de type P par une couche isolante 108. La réalisation de la figure 3B est une réalisation de type FINFET formée à partir d'une partie découpée 104 d'une couche semiconductrice elle-même déposée sur un substrat semiconducteur 110 revêtu d'une couche isolante 111.

On comprendra que la structure peut être simplement fabriquée en formant d'abord un bâtonnet (dans un plan de coupe perpendiculaire au plan de coupe de la figure 3B) dont la partie centrale 104 est dopée de type N, les extrémités du bâtonnet étant fortement dopées de type N (N⁺) pour constituer les régions de source et de drain 101 et 102. Une couche de type P 105 est formée par épitaxie de façon à recouvrir trois côtés de la partie centrale 104. Ensuite, il est procédé à la formation d'une couche isolante 108, par exemple par oxydation thermique ou par dépôt. Enfin, une couche conductrice constituant la grille 107 est déposée sur la couche isolante.

La programmation du point mémoire pourra être effectuée par effet tunnel bande à bande (Band to Band - ou BTB - tunneling), ou par ionisation par impact.

On désignera ci-après par "longueur", les dimensions allant de la source au drain (horizontales en figure 3A), par "largeur" ou épaisseur, les dimensions orthogonales (verticales en figure 3A et horizontales en figure 3B), et par "hauteur", les dimensions verticales dans la représentation de la figure 3B. Le dispositif des figures 3A et 3B pourra alors, à titre d'exemple, avoir les dimensions suivantes :

| | |
|---|---|
| longueur entre drain et source (longueur de canal) : | 22 nm |
| largeur de région N 104 : | 20 nm, |
| épaisseur de région P 105 : | 4 nm, |
| épaisseur d'oxyde de grille : | 2 nm |
| largeur totale (avec la grille) : | 32 nm |

L'exemple ci-dessus est donné dans le cadre d'une technologie dans laquelle la longueur de canal est de 22 nm, mais pourra être adapté au cas des technologies futures dans lesquelles on envisage des longueurs de canal de 14 nm puis de 11 nm. En effet, un avantage du point mémoire décrit ici est que, étant donné la configuration entourante de la grille, on peut conserver une grille efficace même pour des longueurs de grille nettement inférieures à celles qui resteraient efficaces pour des dispositifs dans lesquels la grille est simplement superposée à la région de canal.

Selon un mode de réalisation préféré, la partie centrale de type N de la région intermédiaire est relativement fortement dopée, à un niveau de dopage de l'ordre de 2.10¹⁸ à 2.10¹⁹ atomes par cm³ et la région de type P périphérique est une région quasi intrinsèque d'un niveau de dopage de type P de l'ordre de 10¹⁴ à 10¹⁶ atomes par cm³.

**Les tensions appliquées sur le drain et la grille (la source étant à la masse) pourront alors être les suivantes :**

| Opération | Tension de grille | Tension de drain |
|---|---|---|
| Maintien | < -1 V | 0 V |
| Lecture | < -1 V | 0,1 V |
| Ecriture d'un 0 ou effacement | 1 V | 0 V |
| Ecriture d'un 1 | -2 V | 1,2 V |

Pour l'écriture d'un 1, les tensions de grille et de drain seront appliquées sous forme d'impulsions quasi simultanées, la durée de l'impulsion de drain étant plus courte que celle de l'impulsion de grille dans le cas d'une programmation par effet tunnel bande à bande, et inversement dans le cas d'une programmation par ionisation par impact.

La figure 4A est une vue en perspective d'un autre mode de réalisation, la figure 4B étant une vue en coupe agrandie selon le plan BB de la figure 4A. La structure est formée à partir d'un nanofil semiconducteur. La partie centrale comprend une région de type N 124 entourée d'une région de type P 125, formée par exemple par épitaxie, l'ensemble étant entouré d'une couche conductrice 127 isolée de la région de type P 125 par une couche isolante 128. Les extrémités 121 et 122 sont fortement dopées de type N (N⁺).

Un avantage du point mémoire décrit ici est que l'état 1 est stable. Par contre le maintien d'un état 0 nécessite un rafraîchissement. La durée de rétention peut toutefois être supérieure à 100 ms. On notera que ce temps de rétention est amélioré si, comme cela est illustré en figure 3A, la longueur de la grille est inférieure à la longueur de la région N qu'elle entoure.

Un avantage du point mémoire décrit ici est que sa programmation, son maintien et sa lecture peuvent être assurés par des tensions particulièrement faibles.

Des modes de réalisation particuliers de la présente invention ont été décrits. Diverses variantes et modifications apparaîtront à l'homme de l'art. En particulier, divers matériaux pourront être choisis pour former de l'isolant de grille, notamment de l'oxyde de silicium, du nitrure de silicium, ou des matériaux à forte permittivité.

Par ailleurs, on a décrit en détail ci-dessus un mode de réalisation de l'invention en technologie SOI, dans laquelle un bâtonnet de silicium est formé dans une couche mince de silicium revêtant une couche isolante 111. Selon une variante de réalisation, ce bâtonnet de silicium pourra être défini dans une couche de silicium épitaxiée formée sur un substrat de silicium (substrat massif). Dans le cadre du mode de réalisation décrit ici, ce substrat sera un substrat de type P et la couche épitaxiée sera une couche de type N. On notera que dans le cas d'une réalisation sur substrat massif, le courant de lecture d'un 0 pourra ne pas être strictement nul, mais aura en tout cas une valeur négligeable par rapport au courant de lecture d'un 1.

## Revendications

1. Point mémoire constitué d'un bâtonnet semiconducteur dont les extrémités sont fortement dopées pour constituer des régions de source et de drain (101, 102 ; 121, 122) et dont la partie centrale comprend, entre les régions de source et de drain, une région de type N (104, 124) entourée sur la plus grande partie de sa périphérie d'une région de type P quasi intrinsèque (105, 125), la région de type P étant elle-même entourée d'une grille isolée (107, 127).

2. Point mémoire selon la revendication 1, dans lequel le niveau de dopage de la région de type N (104, 124) est de l'ordre de 2.10¹⁸ à 2.10¹⁹ atomes par cm³ et le niveau de dopage de la région de type P de l'ordre de 10¹⁴ à 10¹⁶ atomes par cm³.

3. Point mémoire selon la revendication 1 ou 2, dans lequel le bâtonnet est constitué d'un morceau de silicium formé dans une couche de silicium sur isolant.

4. Point mémoire selon la revendication 1 ou 2, dans lequel le bâtonnet est constitué d'un morceau d'un nanofil de silicium.

5. Point mémoire selon l'une quelconque des revendications 1 à 4, dans lequel la longueur de la grille (107) est inférieure à la longueur de la région de type P (105) qu'elle entoure.

## Patentansprüche

1. Eine Speicherzelle geformt aus einer Halbleiterstange mit stark dotierten Enden zur Bildung von Source-und Drain-Zonen (101, 102; 121, 122) und die mit ihrem Mittelteil zwischen den Source- und Drain-Zonen eine n-Typ-Zone (104, 124) aufweist, umgeben zum größten Teil auf ihrem Umfang mit einer quasi intrinsischen p-Typ-Zone (105, 125), wobei die p-Typ-Zone selbst mit einem isolierten Gate (107, 127) umgeben ist.

2. Die Speicherzelle nach Anspruch 1, wobei der Dotierpegel der n-Typ-Zone (104, 124) im Bereich von 2 x 10¹⁸ bis 2 x 10¹⁹ Atome pro cm³ liegt und der Dotierpegel der p-Typ-Zone im Bereich von 10¹⁴ bis 10¹⁶ Atome pro cm³ liegt.

3. Die Speicherzelle nach Anspruch 1 oder 2, wobei die Stange aus einem Teil aus Silizium geformt ist, und zwar geformt in einer Silizium-auf-Isolator-Schicht.

4. Die Speicherzelle nach Anspruch 1 oder 2, wobei die Stange aus einem Stück eines Silizium-Nanodrahtes geformt ist.

5. Die Speicherzelle nach einem der Ansprüche 1 bis 4, wobei die Länge des Gates (107) kürzer ist als die Länge der p-Typ-Zone (105), die es umgibt.

## Claims

1. A memory cell formed of a semiconductor rod having ends heavily doped to form source and drain regions (101, 102; 121, 122) and having its central portion comprising, between the source and drain regions, an N-type region (104, 124) surrounded on the most part of its periphery with a quasi-intrinsic P-type region (105, 125), the P-type region being itself surrounded with an insulated gate (107, 127).

2. The memory cell of claim 1, wherein the doping level of the N-type region (104, 124) is in the range from 2.10¹⁸ to 2.10¹⁹ atoms per cm³ and the doping level of the P-type region is in the range from 10¹⁴ to 10¹⁶ atoms per cm³.

3. The memory cell of claim 1 or 2, wherein the rod is formed of a piece of silicon formed in a silicon-on-insulator layer.

4. The memory cell of claim 1 or 2, wherein the rod is formed of a piece of a silicon nanowire.

5. The memory cell of any of claims 1 to 4, wherein the length of the gate (107) is shorter than the length of the P-type region (105) that it surrounds.
